# EUROPEAN PATENT APPLICATION

(11) **EP 4 738 053 A1**
(43) Date of publication of application: **06.05.2026**
(21) Application number: 25202566.3
(22) Date of filing: 16.09.2025
(51) Int. Cl.: G06F 1/16

(54) **DISPLAY DEVICE AND ELECTRONIC DEVICE INCLUDING THE DISPLAY DEVICE**

(30) Priority: 01.11.2024 KR 20240153440
(71) Applicant: Samsung Display Co., Ltd., Yongin-si, Gyeonggi-do (KR)
(72) Inventor: JO, Hyunseong, Yongin-si (KR); KIM, Donghyeon, Yongin-si (KR); KIM, Hanjae, Yongin-si (KR); KIM, Hyungchul, Yongin-si (KR); PARK, Changmin, Yongin-si (KR); SON, Woojong, Yongin-si (KR)
(74) Representative: Marks & Clerk LLP

(57) **Abstract**

A display device according to an embodiment includes a display panel, a supporting member positioned on the back surface of the display panel and including a plurality of first openings, and an adhesive layer positioned between the display panel and the supporting member and overlapping the plurality of first openings, wherein each of the plurality of first openings has a first length in a first direction and a second length in a second direction in a plan view, wherein the first length is longer than the second length, and the adhesive layer overlaps an entirety of the plurality of first openings.

## Description

### BACKGROUND

### (a) Field

The present disclosure relates to a display device and an electronic device including the display device.

### (b) Description of the Related Art

Electronic devices, such as, for example, smartphones, digital cameras, laptop computers, navigation systems, smart televisions, and the like, which provide images to users include a display device for displaying the images. Display devices generate images and provide the generated images to users through a display screen.

Recent technological advances in display devices have led to the development of various types of display devices. For example, various display devices are being developed that can be transformed into a curved, folded, or rolled shape. Display devices are portable and may enhance user convenience.

### SUMMARY

Embodiments attempt to provide a display device that is easily bendable and has openings defined in a supporting member that are not visible from the outside, and an electronic device including the display device.

A display device according to an embodiment includes a display panel, a supporting member positioned on a back surface of the display panel and including a plurality of first openings, and an adhesive layer positioned between the display panel and the supporting member and overlapping the plurality of first openings, wherein each of the plurality of first openings has a first length in a first direction and a second length in a second direction in a plan view, wherein the first length is longer than the second length, and the adhesive layer overlaps all of the plurality of first openings.

The supporting member may include a first region in which the plurality of first openings are disposed, and a second region excluding the first region, and the area of the first region may be greater than the area of the second region.

The display panel may include a display area and a non-display area, and the plurality of first openings may be disposed in the display area.

The display panel may fold or slide about an axis parallel to the first direction.

The adhesive layer may be in direct contact with the plurality of first openings.

A release layer positioned on the back surface of the supporting member may be further included.

The release layer may include a first sub-layer in contact with the supporting member, and a second sub-layer positioned on a back surface of the first sub-layer.

The first sub-layer may include a second opening overlapping one or more first openings among the plurality of first openings.

The second opening may extend in the second direction.

The second opening may cross the one or more first openings.

The first sub-layer may include a plurality of second openings disposed in the first direction.

The plurality of second openings may have different respective widths.

The second opening may extend in a direction inclined with respect to the first direction and the second direction.

A display device according to an embodiment includes a display panel, a supporting member positioned on a back surface of the display panel and including a plurality of first openings, an adhesive layer positioned between the display panel and the supporting member and overlapping the plurality of first openings, and a release layer positioned on a back surface of the supporting member and having a second opening defined therein, wherein each of the plurality of first openings has a shape extending in a first direction on a plane, and the second opening crosses one or more first openings among the plurality of first openings.

The release layer may include a first sub-layer having the second opening, and a second sub-layer positioned on the back surface of the first sub-layer.

The second opening may extend from one end of the first sub-layer to another end of the first sub-layer.

The second opening may extend in a second direction perpendicular to the first direction.

The release layer may include a plurality of second openings disposed in the first direction.

The display panel may fold or slide about an axis parallel to the first direction.

The display panel may include a display area and a non-display area, and the plurality of first openings may be disposed in the display area.

The supporting member may include a first region in which the plurality of first openings are disposed, and a second region excluding the first region, and the area of the first region may be greater than the area of the second region.

The adhesive layer may cover an entirety of the plurality of first openings.

At least some of the above and other features of the invention are set out in the claims.

According to embodiments, the display device may be easily bent. In some aspects, a display device is provided having openings defined in a supporting member that are not visible from the outside, and an electronic device including the display device.

### BRIEF DESCRIPTION OF THE DRAWINGS

FIG. 1 is a block diagram of an electronic device according to an embodiment.
FIGS. 2A and 2B are drawings for describing various states of an electronic device according to an embodiment.
FIG. 3A is a cross-sectional view taken along line A-A' of FIG. 2A, and FIG. 3B is a cross-sectional view taken along line B-B' of FIG. 2B.
FIG. 4 is a schematic perspective view of an electronic device according to an embodiment.
FIG. 5 is a cross-sectional view of a display device according to an embodiment.
FIGS. 6A and 6B are cross-sectional views of a display device according to an embodiment.
FIG. 7 is a perspective view illustrating a display panel, a supporting member, and a release layer according to an embodiment.
FIG. 8 is a top plan view illustrating a release layer and a supporting member according to an embodiment.
FIG. 9 is a perspective view illustrating a portion of a release layer and a supporting member according to an embodiment.
FIGS. 10A, 10B, 11A, 11B, 12A, 12B, 13A, and 13B are schematic cross-sectional views according to a method for manufacturing a display device according to an embodiment.
FIGS. 14 to 19 are top plan views of a supporting member and a release layer according to an embodiment.
FIG. 20 is an image of a display device according to a comparative example.
FIG. 21 is an image of a display device according to an embodiment.

### DETAILED DESCRIPTION

The disclosure will be described more fully hereinafter with reference to the accompanying drawings, in which embodiments of the disclosure are illustrated. As those skilled in the art would realize, the described embodiments may be modified in various different ways, all without departing from the scope of the disclosure.

To concisely describe the disclosure, parts that are irrelevant to the description may be omitted, and like reference numerals and/or reference characters refer to like or similar constituent elements throughout the specification.

Further, since sizes and thicknesses of constituent members illustrated in the accompanying drawings may be arbitrarily given for better understanding and ease of description, the disclosure is not limited to the illustrated sizes and thicknesses. In the drawings, the thicknesses of layers and regions are exaggerated for clarity. In the drawings, for better understanding and ease of description, the thicknesses of some layers and areas may be exaggerated.

It should be understood that when an element such as, for example, a layer, film, region, or substrate is referred to as being "on" another element, it can be directly on the other element or intervening elements may also be present. In contrast, when an element is referred to as being "directly on" another element, there are no intervening elements present. Further, in the specification, the word "on" or "above" means positioned on or below the object portion, and does not necessarily mean being positioned on the upper side of the object portion based on a gravitational direction.

In some aspects, unless explicitly stated to the contrary, the word "comprise," and variations such as, for example, "comprises" and "comprising" should be understood to imply the inclusion of stated elements but not the exclusion of any other elements.

Further, throughout the specification, the phrase "on a plane" means when an object portion is viewed from above, and the phrase "in a cross-sectional view" means when a cross-section taken by vertically cutting an object portion is viewed from the side. Terms such as, for example, first, second, and the like may be used to describe various components, but the components should not be limited by the terms. The terms as used herein may distinguish one component from other components and are not to be limited by the terms. For example, without departing the scope of the present disclosure, a first component may be referred to as a second component, and similarly, the second component may also be referred to as the first component. The terms of a singular form may include plural forms unless otherwise specified.

The terminology used herein is for the purpose of describing particular embodiments and is not intended to be limiting. As used herein, "a," "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items.

The term "substantially," as used herein, means approximately or actually. The term "substantially equal" means approximately or actually equal. The term "substantially the same" means approximately or actually the same. The term "substantially identical" means approximately or actually identical. The term "substantially perpendicular" means approximately or actually perpendicular.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations) and the spatially relative descriptors used herein interpreted accordingly.

Embodiments are described herein with reference to cross section illustrations that are schematic illustrations of example embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases.

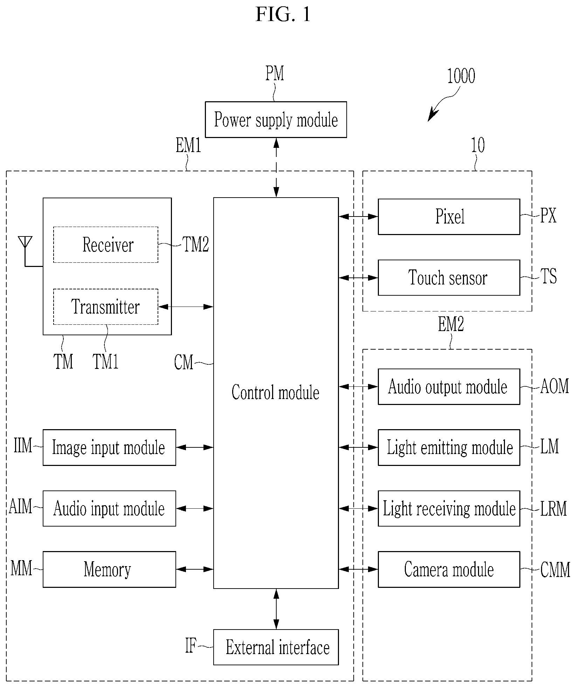

Hereinafter, an electronic device according to an embodiment will be described referring to FIG. 1. FIG. 1 is a block diagram of an electronic device according to an embodiment.

Referring to FIG. 1, an electronic device 1000 may include a display device 10, a power supply module PM, a first electronic module EM1, and a second electronic module EM2. The display device 10, the power supply module PM, the first electronic module EM1, and the second electronic module EM2 may be electrically connected to each other. FIG. 1 illustrates an example of a display pixel PX and a touch sensor TS positioned in a display area of a display panel among the configurations of the display device 10.

The power supply module PM may supply power for the overall operation of the electronic device 1000. The power supply module PM may include a conventional battery module.

The first electronic module EM1 and the second electronic module EM2 may include multiple functional modules for operating the electronic device 1000. The first electronic module EM1 may be mounted directly on a motherboard electrically connected to the display device 10 or may be mounted on a separate substrate and electrically connected to the motherboard through a connector (not illustrated).

The first electronic module EM1 may include a control module CM, a wireless communication module TM, an image input module IIM, an audio input module AIM, a memory MM, and an external interface IF. Some of the modules may not be mounted on the motherboard, but may be electrically connected to the motherboard through a flexible printed circuit board connected thereto.

The control module CM may control the overall operation of the electronic device 1000. The control module CM may be a microprocessor. For example, the control module CM activates or deactivates the display device 10. The control module CM may control other modules, such as, for example, the image input module IIM or the audio input module AIM, based on touch signals received from the display device 10.

The wireless communication module TM may transmit and receive wireless signals with other terminals using Bluetooth or Wi-Fi lines. The wireless communication module TM may transmit and receive voice signals using general communication lines. The wireless communication module TM includes a transmitter TM1 that modulates and transmits a signal to be transmitted, and a receiver TM2 that demodulates a received signal.

The image input module IIM may process an image signal and convert the image signal into image data that can be displayed on the display device 10. The audio input module AIM may receive external audio signals from a microphone in recording mode, voice recognition mode, or the like and convert the external audio signals into electrical voice data.

The external interface IF may act as an interface to connect to an external charger, wired/wireless data port, card socket (e.g., memory card, SIM/UIM card), or the like.

The second electronic module EM2 may include an audio output module AOM, a light emitting module LM, a light receiving module LRM, and a camera module CMM, at least some of which may be positioned on the back surface of the display panel as optical elements. Optical elements may include the light emitting module LM, the light receiving module LRM, and the camera module CMM. In some aspects, the second electronic module EM2 may be mounted directly on the motherboard, mounted on a separate substrate and electrically connected to the display device 10 through a connector (not illustrated), or electrically connected to the first electronic module EM1.

The audio output module AOM may convert audio data received from the wireless communication module TM or audio data stored in the memory MM and output the audio data externally. The light emitting module LM may generate and output light. The light emitting module LM may output infrared rays. For example, the light emitting module LM may include LED elements. For example, the light receiving module LRM may detect infrared rays. The light receiving module LRM may be activated when infrared rays above a certain level are detected. The light receiving module LRM may include a CMOS sensor. After infrared light generated by the light emitting module LM is output, the infrared light may be reflected by an external object (e.g., a user's finger or face), and the reflected infrared light may be incident on the light receiving module LRM. The camera module CMM may capture external images.

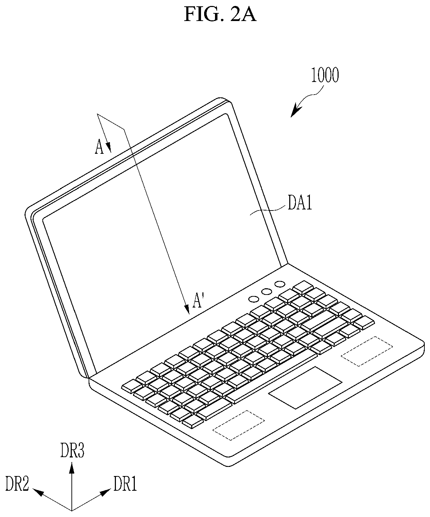

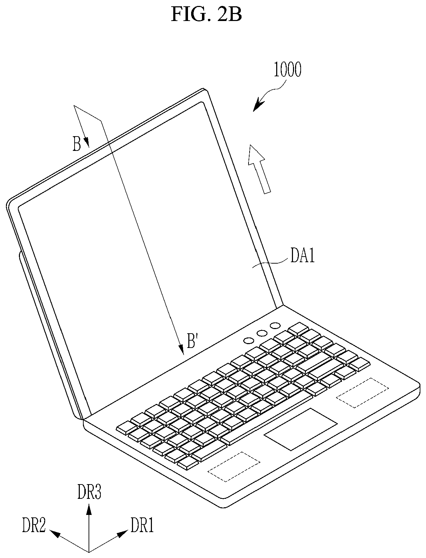

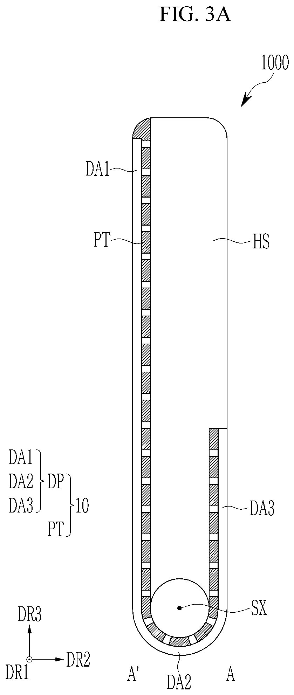

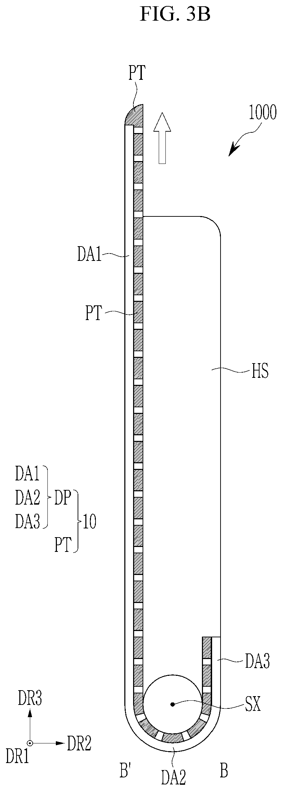

An electronic device according to an embodiment will be described with reference to FIGS. 2A to 3B below. FIGS. 2A and 2B are drawings for describing various states of an electronic device according to an embodiment. FIG. 3A is a cross-sectional view taken along line A-A' of FIG. 2A, and FIG. 3B is a cross-sectional view taken along line B-B' of FIG. 2B.

First, referring to FIGS. 2A and 2B, the electronic device 1000 according to an embodiment may be implemented such that an information display area DA1 of a display device increases or decreases by a sliding motion. Here, the information display area DA1 may be a portion of the display device that is visible outside the electronic device 1000. Information output to the display device may be visually conveyed to the user through the information display area DA1. According to one embodiment, the electronic device 1000 may increase or decrease the width of the information display area DA1 by a sliding motion.

According to an embodiment, the electronic device 1000 may be changed from a reference state (e.g., the state illustrated in FIGS. 2A and 3A) to a sliding state (e.g., the state illustrated in FIGS. 2B and 3B) by a sliding motion.

Referring to FIGS. 2A and 3A, the reference state of the electronic device 1000 may refer to a state in which the end of a housing HS and the end of a supporting member PT are substantially aligned. For example, as illustrated in FIG. 3A, the reference state may refer to a state in which the supporting member PT does not protrude with respect to the housing HS. The reference state may refer to a state in which the housing HS and the supporting member PT are aligned. The reference state may be referred to a closed state or a slide-in state.

The sliding state may refer to a state in which the supporting member PT slides with respect to the housing HS in the reference state of FIG. 3A, as illustrated in FIGS. 2B and 3B. As illustrated in FIGS. 2B and 3B, the area of the information display area DA1 in the sliding state may be larger than the area of the information display area DA1 in the reference state. The sliding state may be understood as an opened state or a slide-out state. The display device 10 in which the area of the display area DA1 changes based on the sliding motion may be defined as a "slidable display device."

According to an embodiment, the display device 10 may be a flexible display device capable of bending. In an embodiment, the display device 10 may include a substrate formed of a flexible material. For example, the display device 10 may include a substrate formed of a polymer material such as, for example, a flexible material such as, for example, polyimide (PI) or polyethylene terephthalate (PET). In some aspects, the display device 10 may include a substrate formed of thinly formed glass material. The information display area DA1 of the display device 10, which is an externally visible portion of the display panel DP, may increase or decrease by sliding it.

In an embodiment, the display device 10 may further include a touch sensing circuit (e.g., a touch sensor). In some aspects, the display device 10 may be combined with or disposed adjacent to a pressure sensor capable of measuring the intensity (pressure) of a touch and/or a digitizer capable of detecting a magnetic pen input device (e.g., a stylus pen). For example, the digitizer may include a coil element disposed on a dielectric substrate such that the digitizer may detect a resonant frequency of electromagnetic induction applied from the pen input device.

According to various embodiments, the supporting member PT may support the display panel DP. In an example in which the display device 10 slides, the supporting member PT may move along the display panel DP.

According to various embodiments, the display panel DP may include a plurality of regions. The plurality of regions described herein may be regions divided according to the portion where the display panel DP is positioned in the electronic device 1000. For example, the display panel DP may include the information display area DA1, which is an area where the display panel DP is exposed to the outside of the electronic device 1000, a storage area DA3, which is an area stored inside the electronic device 1000, and a bending area DA2, which is an area that connects and bends the information display area DA1 and the storage area DA3. The information display area DA1, the bending area DA2, and the storage area DA3 may all be display areas that display images.

In an embodiment, a portion of the bending area DA2 may also be visible outside the electronic device 1000 based on the shape of the housing HS surrounding the display panel DP.

As the display device 10 slides, the sizes of the information display area DA1 and the storage area DA3 may be varied. For example, the size of the information display area DA1 in the reference state (e.g., the state illustrated in FIG. 3A) may be smaller than the size of the information display area DA1 in the sliding state (e.g., the state illustrated in FIG. 3B). The size of the storage area DA3 in the reference state may be larger than the size of the storage area DA3 in the sliding state. Each area of the display panel DP is separated for convenience of description and may not be an area that is actually visually distinct.

The display device 10 according to an embodiment may be slidable about an axis SX parallel to a first direction DR1.

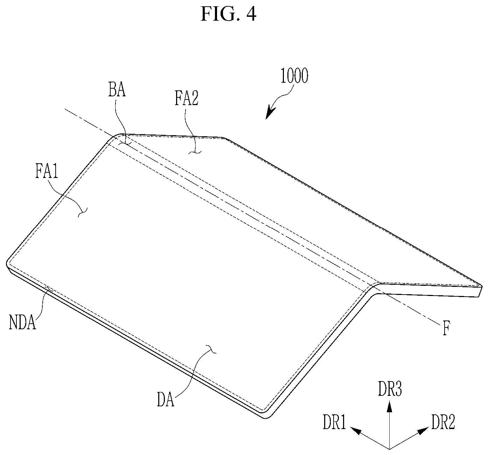

Hereinafter, an electronic device according to an embodiment is described referring to FIG. 4. FIG. 4 is a schematic perspective view of an electronic device according to an embodiment.

Referring first to FIG. 4, the first direction DR1 may be a direction parallel to one side of the electronic device 1000 when viewed on a plane-for example, a vertical direction of the electronic device 1000. A second direction DR2 may be a horizontal direction of the electronic device 1000, which is parallel to the other side that is in contact with one side of the electronic device 1000 when viewed on a plane. A third direction DR3 may be the thickness direction of the electronic device 1000.

The electronic device 1000 includes a display area DA where an image is displayed and a non-display area NDA excluding the display area. The display area DA may be an area that displays an image and includes a plurality of pixels. The non-display area NDA is an area that does not contain pixels and may be disposed around the display area DA.

The electronic device 1000 may be unfolded flat overall. The electronic device 1000 may include a first flat area FA1, a second flat area FA2, and a foldable area BA positioned between the first flat area FA1 and the second flat area FA2. The foldable area BA is an area that folds when folded based on a folding axis F, and the first flat area FA1 and the second flat area FA2 are areas that do not fold. The foldable area BA may be folded about an axis parallel to the first direction DR1.

Although FIG. 4 illustrates one foldable area BA, the electronic device 1000 according to an embodiment may include one or more foldable areas BA. One or more foldable areas BA may be folded based on different axes, for example, an axis parallel to the first direction DR1 and/or an axis parallel to the second direction DR2, and the position and width of the foldable areas BA in the electronic device 1000 may be variously changed.

The electronic device 1000 may maintain both a folded state and an unfolded state. The electronic device 1000 may be folded in an in-folding manner in which the display area DA is positioned on the inside or in an out-folding manner in which the display area DA is positioned on the outside. In an example in which the electronic device 1000 is folded in the in-folding manner, the front surfaces of the electronic devices 1000 may face each other. In an example in which the electronic device 1000 is folded in the out-folding manner, the back surfaces of the electronic device 1000 may face each other.

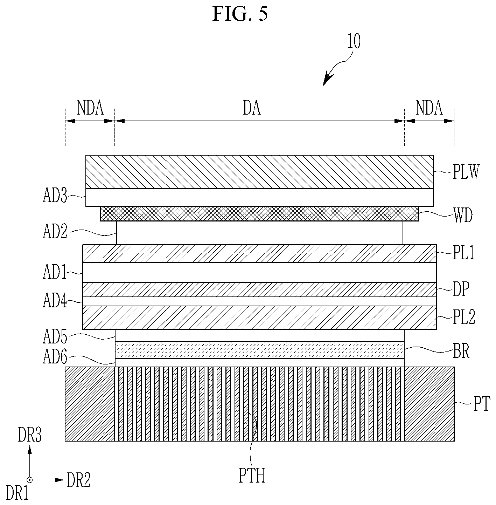

Referring to the following FIG. 5, a stacking structure of a display device included in an electronic device according to an embodiment will be described. FIG. 5 is a cross-sectional view of a display device according to an embodiment. The electronic device described herein includes a display device described herein.

Referring to FIG. 5, the display device 10 according to an embodiment may include a window protective layer PLW, a window WD, a first protective layer PL1, the display panel DP, a second protective layer PL2, a barrier layer BR, and the supporting member PT.

Each component configuring the display device 10 may be attached by adhesive layers AD1, AD2, AD3, AD4, AD5, and AD6. Each of the adhesive layers AD1, AD2, AD3, AD4, AD5, and AD6 may be a pressure-sensitive adhesive (PSA). The adhesive layers AD1, AD2, AD3, AD4, AD5, and AD6 may be either an optically clear adhesive (OCA) or an optically clear resin (OCR). Each of the adhesive layers AD1, AD2, AD3, AD4, AD5, and AD6 may be the same or different.

The display panel DP may be any one of a light emitting display panel, a quantum-dot display panel, an LED display panel, a liquid crystal display panel, a plasma display panel, an electrophoretic display panel, a microelectromechanical system (MEMS) display panel, and an electrowetting display panel, but is not limited thereto.

The first protective layer PL1 is positioned on the display panel DP and may protect the display panel DP. Based on an embodiment, the first protective layer PL1 may also have an anti-reflection function to prevent external light from being reflected and escaping from the inside of the display panel DP.

Although not illustrated in this specification, based on an embodiment, the first protective layer PL1 may be disposed between the window WD and the window protective layer PLW, which will be described later. The first protective layer PL1 may include, for example, polyethylene terephthalate resin or polyimide.

The window WD is disposed on the front surface of the first protective layer PL1 and serves to protect the display panel DP. The window WD may be attached to the front surface of the first protective layer PL1 by a second adhesive layer AD2.

The window WD is formed of a transparent material, which may include glass or plastic, for example. For example, the window WD may include ultrathin glass (UTG) having a thickness of 0.1 mm or less, transparent polyimide, polyethylene terephthalate (PET), polycarbonate (PC), or the like.

The window protective layer PLW may be disposed on the front surface of the window WD. The window protective layer PLW may be attached to the front surface of the window WD by a third adhesive layer AD3. The window protective layer PLW may perform at least one of the functions of preventing splashing, absorbing impact, preventing scratches, preventing fingerprints, and preventing glare of the window WD.

The second protective layer PL2 may be disposed on the back surface of the display panel DP. The second protective layer PL2 may be attached to the back surface of the display panel DP by a fourth adhesive layer AD4. The second protective layer PL2 may support the display panel DP and protect the back surface of the display panel DP.

The barrier layer BR may be disposed on the back surface of the second protective layer PL2. The barrier layer BR may be attached to the back surface of the second protective layer PL2 by a fifth adhesive layer AD5. The barrier layer BR may prevent the penetration of moisture and oxygen from the outside. Based on embodiments, the barrier layer BR may be omitted.

The barrier layer BR may increase resistance to compressive force due to external pressure. The barrier layer BR may serve to prevent deformation of the display panel DP. The barrier layer BR may include a flexible plastic material such as, for example, polyimide or polyethylene terephthalate.

The barrier layer BR may have a color that absorbs light. For example, the barrier layer BR may have a black color. In this case, when viewing the display device 10 from above, components disposed under the barrier layer BR may not be visible.

The supporting member PT may be disposed on the back surface of the barrier layer BR to increase the strength and rigidity of the display device 10. The supporting member PT may be attached to the back surface of the barrier layer BR by a sixth adhesive layer AD6.

The sixth adhesive layer AD6 may be provided with substantially the same size as the barrier layer BR. In some aspects, the sixth adhesive layer AD6 may overlap most of the display area DA of the display panel DP. The sixth adhesive layer AD6 may contact an entire opening PTH of the supporting member PT. The sixth adhesive layer AD6 may also be disposed in an area where the display panel DP is bent, such as, for example, a foldable area, a bending area, or a sliding area.

The supporting member PT may include a non-metallic material. The supporting member PT may include at least one reinforced fiber composite based on an embodiment. For example, the supporting member PT may include at least one of carbon fiber reinforced plastic (CFRP) and glass fiber reinforced plastic (GFRP). Alternatively, based on an embodiment, the supporting member PT may include a metal such as, for example, SUS, Al, Mg, or Ti.

The supporting member PT may include a reinforced fiber composite to reduce weight. The supporting member PT according to an embodiment may have light weight compared to a metal support plate using a metal material by including a reinforced fiber composite, while having a modulus and strength similar to those of the metal support plate.

In some aspects, since the supporting member PT includes a reinforced fiber composite, the shape processing of the supporting member PT may be made easier compared to the metal support plate. For example, the supporting member PT including the reinforced fiber composite may be more easily processed through a laser process or a micro-blast process. However, this is an example and is not limited thereto, and the supporting member PT may include a metallic material.

The supporting member PT according to an embodiment may include a plurality of first openings PTH. The plurality of first openings PTH may have a shape extending in the first direction DR1. The plurality of first openings PTH may be formed by a laser process or a micro-blast process. The plurality of first openings PTH may be defined in an area where sliding or folding of the display device occurs, thereby increasing the flexibility of the supporting member PT. As a result, the supporting member PT may be folded or slid based on the use of the device. The supporting member PT may fold or slide based on the use of the device.

The supporting member PT may overlap the display area DA and the non-display area NDA. The plurality of first openings PTH may overlap the display area DA. The plurality of first openings PTH may be disposed throughout the display area DA. In some examples, the plurality of first openings PTH may be disposed throughout the display area DA. The supporting member PT may include a first region in which the first opening PTH is disposed and a second region in which the first opening PTH is not disposed. The first region may substantially overlap the display area DA, and the second region may overlap the non-display area NDA. In the supporting member PT, the area of the first region where the first opening PTH is disposed may be greater than the area of the second region where the first opening PTH is not disposed.

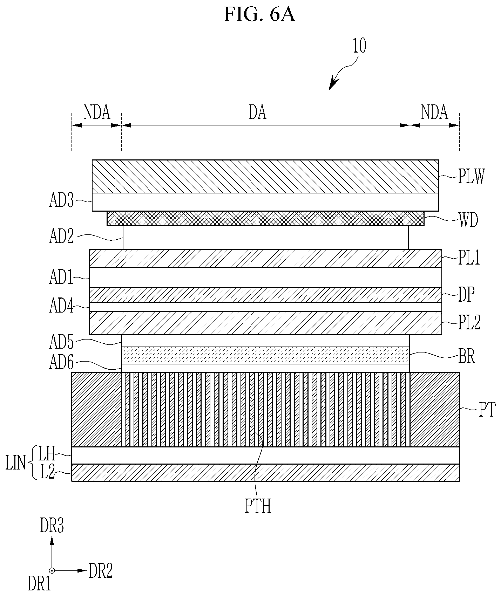

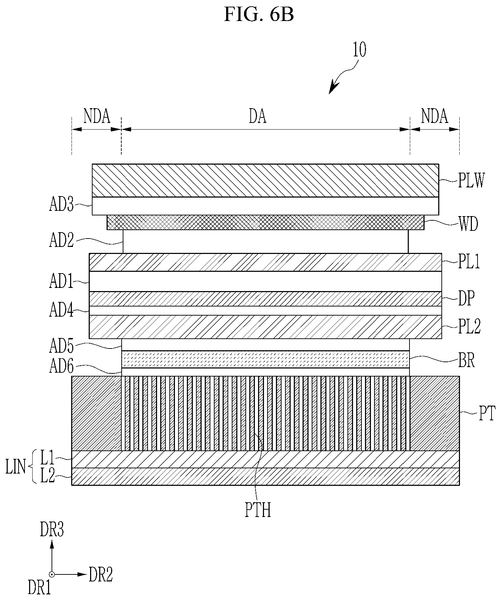

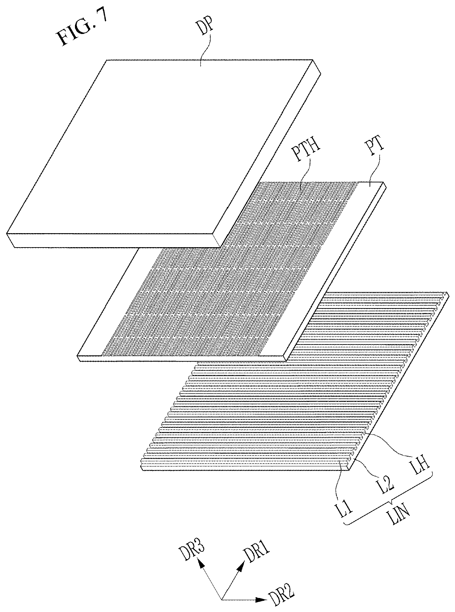

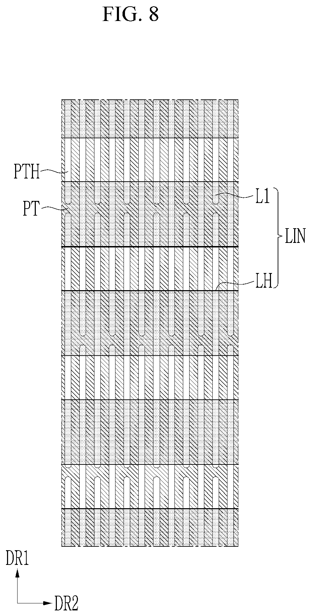

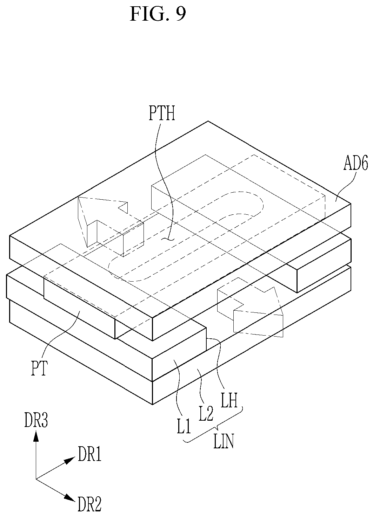

Hereinafter, a display device including a release layer will be described referring to FIGS. 6A to 9. FIGS. 6A and 6B are cross-sectional views of a display device according to an embodiment, FIG. 7 is a perspective view illustrating some components, FIG. 8 is a top plan view illustrating a release layer and a supporting member according to an embodiment, and FIG. 9 is a perspective view illustrating a portion of a release layer and a supporting member according to an embodiment. Descriptions of components that are the same as those described herein will be omitted.

Referring to FIGS. 6A and 6B, the display device 10 according to an embodiment may further include a release layer LIN positioned on the back surface of the supporting member PT. The release layer LIN may be separated and removed from the supporting member PT as applicable or desired in accordance with one or more embodiments of the present disclosure. Based on embodiments, the display device 10 may be provided in the form of FIG. 5 with the release layer LIN removed.

The release layer LIN may include a first sub-layer L1 positioned on the back surface of the supporting member PT and a second sub-layer L2 positioned on the back surface of the first sub-layer L1. The first sub-layer L1 may be in contact with the supporting member PT. The first sub-layer L1 may be positioned between the supporting member PT and the second sub-layer L2.

Although this specification describes an embodiment in which the release layer LIN includes the first sub-layer L1 and the second sub-layer L2, embodiments of the present disclosure are not limited thereto, and the release layer LIN may be formed of two or more layers. Based on the embodiments, the release layer LIN may further include a third sub-layer.

As illustrated in FIG. 6A, the first sub-layer L1 may include a plurality of second openings LH. The plurality of second openings LH may be defined in the thickness direction of the first sub-layer L1. The thickness of the first sub-layer L1 and the thickness of a second opening LH may be the same.

Referring to FIGS. 7 and 8, each of the plurality of second openings LH may extend in the second direction DR2. The plurality of second openings LH may be disposed in the first direction DR1. Although this specification illustrates an embodiment in which the gap and width of the plurality of second openings LH are the same, the gap between the plurality of second openings LH and the respective widths may be changed based on the embodiment.

The second opening LH may extend from one end of the first sub-layer L1 to the other end in the second direction DR2. The second opening LH may reach both edges of the first sub-layer L1 parallel to the first direction DR1. The second opening LH may be an air passage.

As illustrated in FIGS. 7 and 8, the plurality of first openings PTH included in the supporting member PT may extend in the first direction DR1. The plurality of first openings PTH may be repeatedly disposed in the first direction DR1 and the second direction DR2. In some aspects, the plurality of first openings PTH adjacent to each other in the second direction DR2 may be alternately disposed on a plane. The plurality of first openings PTH may extend longer in the first direction DR1 than in the second direction DR2. Expressed another way, each of the plurality of first openings PTH may have a first dimension (also referred to herein as a first length, or a length) which is longer in the first direction DR1 than a second dimension (also referred to herein as a second length, or a width) in the second direction DR2. The first direction DR1 is the reference axis along which sliding occurs, as previously described, or is the direction parallel to the axis along which folding occurs.

The second opening LH included in the first sub-layer L1 may have a shape extending in the second direction DR2. The direction in which the second opening LH extends may be different from the direction in which the first opening PTH extends. The direction in which the second opening LH extends and the direction in which the first opening PTH extends may be perpendicular.

The second opening LH may overlap at least a portion of the first opening PTH. In some aspects, the second opening LH may cross at least a portion of the first opening PTH.

As illustrated in FIG. 9, during the manufacturing process of the display device, the first opening PTH of the supporting member PT may be bonded under vacuum conditions during the bonding process of the sixth adhesive layer AD6 and the supporting member PT. In an embodiment, the release layer LIN provides a passage through which air can move through the second opening LH of the first sub-layer L1. Therefore, even when bonded under a vacuum, air may move along the first opening PTH of the supporting member PT and the second opening LH of the first sub-layer L1.

If the release layer LIN does not include the second opening LH, a vacuum may be formed in the first opening PTH. The upper surface of the supporting member PT may be blocked by the adhesive layer AD6, and the lower surface of the supporting member PT may be blocked by the release layer. Therefore, when a vacuum is formed, shrinkage occurs at the first opening PTH, and since the display panel DP is bonded in the shrinkage state, bending of the display panel DP may be caused. In some aspects, the shape of the first opening PTH may be visible to the outside, which may cause the quality of the display device to deteriorate.

However, according to an embodiment, even when the display panel DP and the supporting member PT are bonded in a vacuum state, a passage for air to escape is provided, thereby preventing bending of the display device and visibility of the first opening.

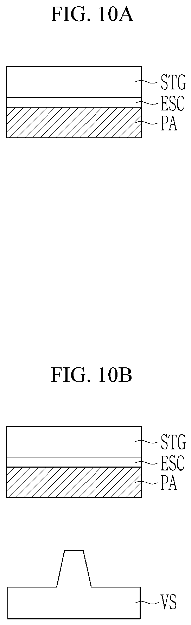

Hereinafter, a method for manufacturing a display device according to an embodiment will be described in more detail with reference to FIGS. 10A, 10B, 11A, 11B, 12A, 12B, 13A, and 13B. FIGS. 10A, 10B, 11A, 11B, 12A, 12B, 13A, and 13B are schematic cross-sectional views according to a method for manufacturing a display device according to an embodiment.

First, referring to FIG. 10A, a display panel assembly PA may be coupled to a stage STG on which an electrostatic chuck ESC is disposed. The display panel assembly PA may refer to a structure stacked from the display panel DP described herein to the window protective layer PLW. Then, as illustrated in FIG. 10B, the described display panel assembly PA may be disposed at a specific position using an alignment device VS.

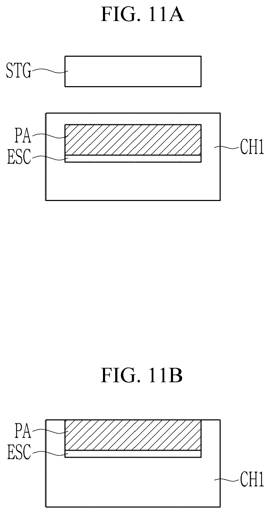

As illustrated in the following FIG. 11A, the display panel assembly PA is loaded into a first chamber CH1. The display panel assembly PA loaded into the first chamber CH1 may be disposed upward as illustrated in FIG. 11B.

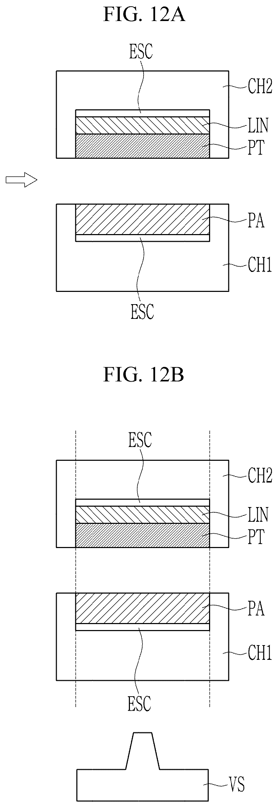

Then, as illustrated in FIG. 12A, the supporting member PT and the release layer LIN loaded in the second chamber CH2 are disposed adjacent to the first chamber CH1. As illustrated in the following FIG. 12B, the display panel assembly PA and the supporting member PT are aligned using the alignment device VS.

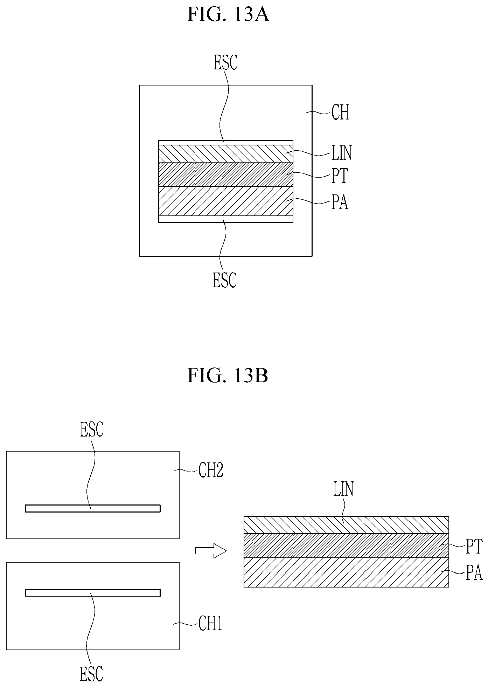

As illustrated in the following FIG. 13A, the display panel assembly PA and the supporting member PT are bonded in the vacuum state. The vacuum state may be used to remove bubbles. In this case, for example, the release layer LIN according to an embodiment provides a passage through which air can move through the second opening of the first sub-layer described herein. Accordingly, air may move through the first opening of the supporting member PT and the second opening of the release layer. The display panel assembly PA to be bonded may be provided flat and unbent. In some aspects, the shape of the first opening included in the supporting member PT may not be visible. Then, the manufactured display device is discharged as illustrated in FIG. 13B.

A display device according to an embodiment may be provided including a release layer having a passage through which air can move. Therefore, even if the vacuum state is provided during the manufacturing process, the problem of the display panel being bent or the opening being visible may be solved by providing an air passage.

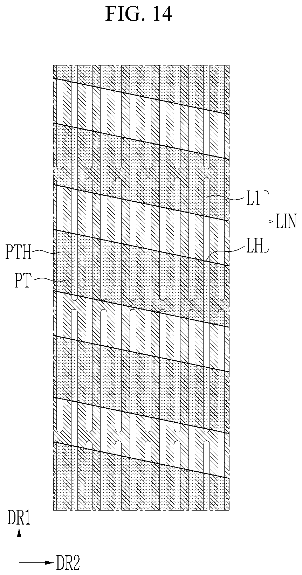

Hereinafter, with reference to FIGS. 14 to 19, the shape of the supporting member and the release layer according to an embodiment will be described. FIGS. 14 to 19 are top plan views of a supporting member and a release layer according to an embodiment. Descriptions of components that are the same as those described herein will be omitted.

Referring to FIG. 14, the supporting member PT according to an embodiment may include the plurality of first openings PTH extending in the first direction DR1.

The plurality of first openings PTH may be arranged according to a predetermined rule. The plurality of first openings PTH may be arranged in the first direction DR1 and the second direction DR2. When viewed on a plane, the plurality of first openings PTH adjacent to each other in the second direction DR2 may be alternately disposed. The plurality of first openings PTH may extend longer in the first direction DR1 than in the second direction DR2. That is, the plurality of first openings PTH may extend in a direction parallel to the folding axis or sliding axis described herein.

As illustrated in FIG. 14, the release layer LIN may include the second opening LH extending in the second direction DR2. The plurality of second openings LH may be spaced apart in the first direction DR1.

The second opening LH may have a stripe shape on a plane. The second opening LH may have a shape inclined with respect to the first direction DR1 and the second direction DR2. The second opening LH may cross the plurality of first openings PTH. The second opening LH may cross the plurality of first openings PTH in a direction inclined with respect to the first direction DR1 and the second direction DR2.

In the embodiment of FIG. 14, the release layer LIN is illustrated as including the first sub-layer L1, and the second sub-layer is formed such that the second sub-layer overlaps the front surface of the supporting member PT, which is not illustrated separately. The second sub-layer may be applied in the shape of the previous embodiment, and the third sub-layer may also be applied based on the embodiment.

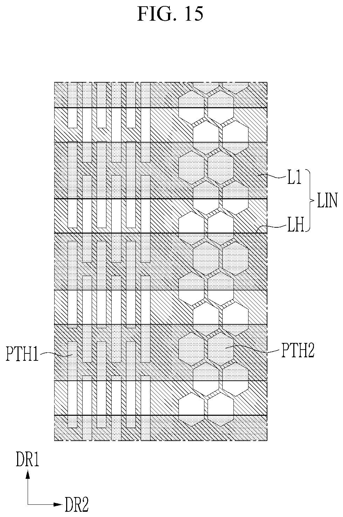

Referring to FIG. 15, the supporting member PT according to an embodiment may include a first sub-opening PTH1 and a second sub-opening PTH2. The first sub-opening PTH1 and the second sub-opening PTH2 may have different shapes on a plane. For example, the first sub-opening PTH1 may have a rod shape extending in the first direction DR1. A plurality of first sub-openings PTH1 may be disposed in the first direction DR1 and in the second direction DR2. The plurality of first sub-openings PTH1 on a plane may be alternately disposed. The second sub-opening PTH2 may have a hexagonal shape on a plane. The adjacent second sub-openings PTH2 may be disposed such that the two facing sides are parallel. This specification provides examples of shapes of the first sub-opening PTH1 and the second sub-opening PTH2, and the shapes of the first sub-opening PTH1 and the second sub-opening PTH2 may be changed based on the embodiment. The first sub-opening PTH1 and the second sub-opening PTH2 may be spaced apart from each other in the second direction DR2.

The second opening LH may have a stripe shape on a plane. The second opening LH may extend in the second direction DR2. The second opening LH may cross the first sub-opening PTH1 and the second sub-opening PTH2. The second opening LH may cross the plurality of first sub-openings PTH1 and second sub-openings PTH2 having different shapes.

In the embodiment of FIG. 15, the release layer LIN is illustrated as including the first sub-layer L1, and the second sub-layer is formed such that the second sub-layer overlaps the front surface of the supporting member PT, which is not illustrated separately. The second sub-layer may be applied in the shape of the previous embodiment, and the third sub-layer may also be applied based on the embodiment.

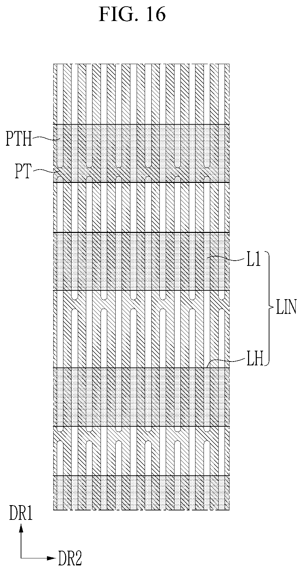

Referring to FIG. 16, the width of the second opening LH according to an embodiment may vary. The release layer LIN may include the plurality of second openings LH. Some of the plurality of second openings LH may have a first width, and the remaining second openings LH may have a second width. The first width and the second width may be different. Although this specification illustrates two widths for the second openings LH, embodiments of the present disclosure are not limited thereto, and each of the plurality of second openings LH may have different respective widths.

According to an embodiment, the second opening LH having the first width and the second opening LH having the second width may be alternately disposed. However, without being limited thereto, the second opening LH having the first width and the second opening LH having the second width may be disposed in various ways.

In the embodiment of FIG. 16, the release layer LIN is illustrated as including the first sub-layer L1, and the second sub-layer is formed such that the second sub-layer overlaps the front surface of the supporting member PT, which is not illustrated separately. The second sub-layer may be applied in the shape of the previous embodiment, and the third sub-layer may also be applied based on the embodiment.

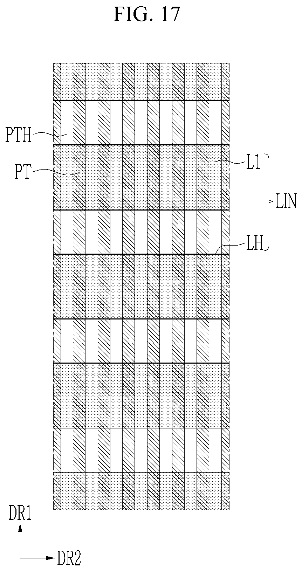

Referring to FIG. 17, the supporting member PT according to an embodiment may include a plurality of first openings PTH. Each of the plurality of first openings PTH may have a rod shape extending in the first direction DR1. The first opening PTH may extend from one end of the supporting member PT to the other end. According to an embodiment, the plurality of first openings PTH may be spaced apart from each other in the second direction DR2.

The second opening LH may have a stripe shape on a plane. The second opening LH may extend in the second direction DR2. The second opening LH may cross the plurality of first openings PTH.

In the embodiment of FIG. 17, the release layer LIN is illustrated as including the first sub-layer L1, and the second sub-layer is formed such that the second sub-layer overlaps the front surface of the supporting member PT, which is not illustrated separately. The second sub-layer may be applied in the shape of the previous embodiment, and the third sub-layer may also be applied based on the embodiment.

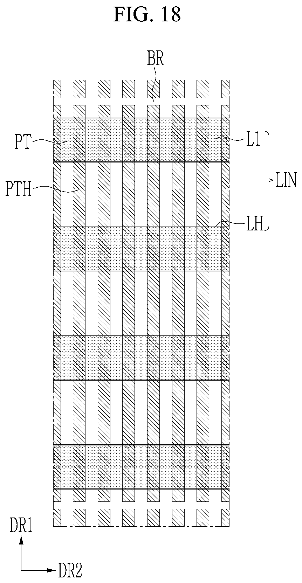

Referring to FIG. 18, the supporting member PT according to an embodiment may include a plurality of first openings PTH. Each of the plurality of first openings PTH may have a rod shape extending in the first direction DR1.

The supporting member PT according to an embodiment may include a connecting portion BR extending in the second direction DR2. The plurality of first openings PTH disposed in the first direction DR1 may be spaced apart by the connecting portion BR.

The second opening LH may have a stripe shape on a plane. The second opening LH may extend in the second direction DR2. The second opening LH may cross the plurality of first openings PTH.

In the embodiment of FIG. 18, the release layer LIN is illustrated as including the first sub-layer L1, and the second sub-layer is formed such that the second sub-layer overlaps the front surface of the supporting member PT, which is not illustrated separately. The second sub-layer may be applied in the shape of the previous embodiment, and the third sub-layer may also be applied based on the embodiment.

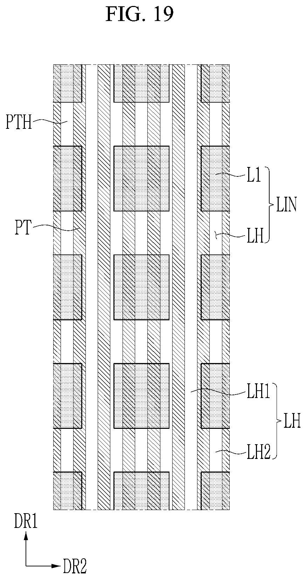

Referring to FIG. 19, the supporting member PT according to an embodiment may include a plurality of first openings PTH. Each of the plurality of first openings PTH may have a rod shape extending in the first direction DR1. The plurality of first openings PTH may be disposed in the second direction DR2.

The second opening LH may be a mesh shape on a plane. The second opening LH may include a first portion LH1 extending in the first direction DR1 and a second portion LH2 extending in the second direction DR2. The first portion LH1 and the second portion LH2 may be connected to each other. The first portion LH1 may extend in the same direction as the first opening PTH. The first portion LH1 may overlap at least a portion of the first opening PTH. The second portion LH2 may extend in a direction crossing the first opening PTH. The second portion LH2 may overlap the plurality of first openings PTH.

In the embodiment of FIG. 19, the release layer LIN is illustrated as including the first sub-layer L1, and the second sub-layer is formed such that the second sub-layer overlaps the front surface of the supporting member PT, which is not illustrated separately. The second sub-layer may be applied in the shape of the previous embodiment, and the third sub-layer may also be applied based on the embodiment.

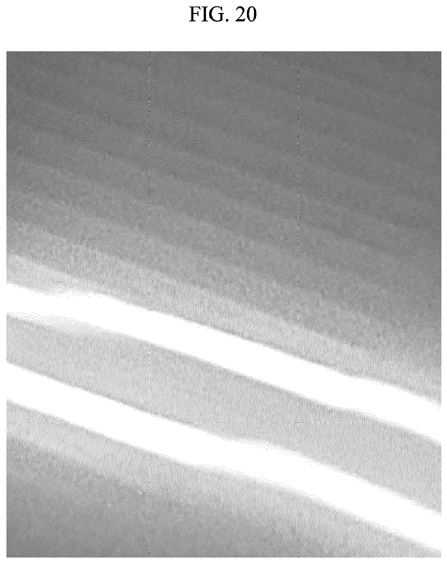

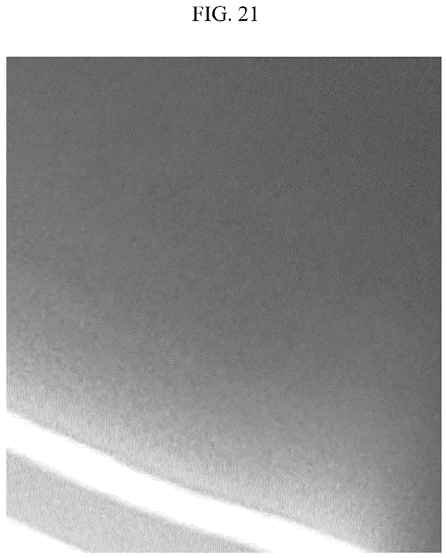

Hereinafter, display devices according to examples and comparative examples will be described with reference to FIGS. 20 and 21. FIG. 20 is an image of a display device according to a comparative example, and FIG. 21 is an image of a display device according to an embodiment.

FIG. 20 is an image of a display device including a release layer having a planar shape according to a comparative example, and FIG. 21 is an image of a display device to which a release layer including the second opening is attached according to an embodiment. Referring to FIG. 20, when including a release layer having a planar shape, vacuum adsorption is formed at the first opening of the supporting member, such that the shape of the first opening may be recognized by the user. However, if the release layer includes a second opening as in FIG. 21, vacuum absorption at the first opening may be prevented and air may be allowed to move, thereby preventing bending of the display device and visibility of the first opening.

A display device according to an embodiment may prevent vacuum adsorption that occurs during a manufacturing process of the display device by providing a release layer including the second opening. Accordingly, even when the display panel and the supporting member are bonded in a vacuum state, a passage for air to escape is provided, thereby preventing bending of the display device and improving the quality of the display device.

While this disclosure has been described in connection with what is presently considered to be practical embodiments, it should be understood that the disclosure is not limited to the disclosed embodiments, but, on the contrary, is intended to cover various modifications and equivalent arrangements included within the scope of the appended claims.

## Claims

1. A display device (10) comprising:
a display panel (DP);
a supporting member (PT) positioned on a back surface of the display panel (DP) and comprising a plurality of first openings (PTH); and
an adhesive layer (AD6) positioned between the display panel (10) and the supporting member (PT) and overlapping the plurality of first openings (PTH),
wherein:
each of the plurality of first openings (PTH) has a first length in a first direction (DR1) and a second length in a second direction (DR2) in a plan view, wherein the first length is longer than the second length, and
the adhesive layer (AD6) overlaps all of the plurality of first openings (PTH).

2. The display device (10) of claim 1, wherein:
the supporting member (PT) comprises:
a first region in which the plurality of first openings (PTH) are disposed; and
a second region excluding the first region, and
an area of the first region is greater than an area of the second region.

3. The display device (10) of claim 1 or claim 2, wherein:
the display panel (DP) comprises a display area (DA) and a non-display area (NDA), and
the plurality of first openings (PTH) are disposed in the display area (DA).

4. The display device (10) of any one of claims 1 to 3, wherein the display panel (DP) folds or slides about an axis (SX) parallel to the first direction (DR1).

5. The display device (10) of any one of claims 1 to 4, wherein the adhesive layer (AD6) is in direct contact with the plurality of first openings (PTH).

6. The display device (10) of any one of claims 1 to 5, further comprising a release layer (LIN) positioned on a back surface of the supporting member (PT).

7. The display device (10) of claim 6, wherein the release layer (LIN) comprises:
a first sub-layer (L1) in contact with the supporting member (PT); and
a second sub-layer (L2) positioned on a back surface of the first sub-layer (L1).

8. The display device (10) of claim 7, wherein the first sub-layer (L1) comprises a second opening (LH) overlapping one or more first openings (PTH) among the plurality of first openings (PTH).

9. The display device (10) of claim 8, wherein the second opening (LH) extends in the second direction (DR2).

10. The display device (10) of claim 8 or claim 9, wherein the second opening (LH) crosses the one or more first openings (PTH).

11. The display device (10) of any one of claims 8 to 10, wherein the first sub-layer (L1) comprises a plurality of second openings (LH) disposed in the first direction (DR1).

12. The display device (10) of claim 11, wherein the plurality of second openings (LH) have different respective widths.

13. The display device (10) of any one of claims 8 to 12, wherein the second opening (LH) extends in a direction inclined with respect to the first direction (DR1) and the second direction (DR2).

14. The display device (10) of claim 8, wherein the second opening extends in the second direction perpendicular to the first direction.

15. The display device (10) of claim 14, wherein the second opening extends from an end of the first sub-layer to another end of the first sub-layer.
